# FASCICULE DE BREVET EUROPEEN

(11) **EP 2 499 890 B1**
(45) Date de publication et mention de la délivrance du brevet: **30.04.2014**
(21) Numéro de dépôt: 10785116.4
(22) Date de dépôt: 15.10.2010
(51) Int. Cl.: H05K 7/14, A63H 27/00, B64C 39/02

(54) **SUPPORT DE CARTE ELECTRONIQUE DE NAVIGATION POUR DRONE A VOILURE TOURNANTE**
HALTER FÜR EINE ELEKTRONISCHE NAVIGATIONSKARTE FÜR EINE ROTORDROHNE
ELECTRONIC NAVIGATION CARD HOLDER FOR A ROTOR DRONE

(30) Priorité: 13.11.2009 FR 0958011
(43) Date de publication de la demande: 19.09.2012
(73) Titulaire: Parrot, 75010 Paris (FR)
(72) Inventeur: SAVOYE, Guillaume, F-75011 Paris (FR); MORRA, Flavien, F-93500 Pantin (FR); VUILLET, Jean-François, F-78000 Versailles (FR)
(74) Mandataire: Dupuis-Latour, Dominique
(86) Numéro de dépôt international: PCT/FR2010/052186
(87) Numéro de publication internationale: WO 2011/058255

(56) Documents cités:
- EP-A2- 2 028 917
- US-A- 6 142 419
- US-A1- 2004 150 144
- US-A1- 2005 061 909
- US-A1- 2007 105 474

## Description

La présente invention concerne un support de carte électronique de navigation pour un drone à voilure tournante.

L'invention trouve une application particulièrement avantageuse dans le domaine des jouets radiocommandés pouvant être utilisés par des enfants, notamment dans des environnements d'intérieur, comme une pièce d'une maison ou d'un appartement, par exemple.

On entend ici par drone à voilure tournante toutes les formules d'hélicoptères connues, à savoir la formule classique mono-rotor avec rotor anti-couple, la formule tandem à birotor banane, la formule Kamof à rotors coaxiaux contrarotatifs, et la formule quadricoptère, ou quadri-rotor, à quatre rotors à pas fixe, etc.

Dans un drone du type quadricoptère par exemple, la voilure tournante est constituée de quatre groupes propulsifs comprenant, chacun, une hélice entraînée par un moteur électrique par l'intermédiaire d'un système de réduction de la vitesse de rotation, généralement très élevée, du moteur. Le moteur d'entraînement de chaque groupe propulsif comporte une carte électronique recevant des signaux de commande établis, en fonction des paramètres de vol, par une carte électronique de navigation unique, commune à l'ensemble des groupes propulsifs.

Du point de vue structurel, les éléments fonctionnels qui viennent d'être présentés sont portés par une carène comprenant quatre armatures circulaires disposées entre elles en carré et aux centres desquelles sont placés les groupes propulsifs.

Les armatures circulaires de la carène sont organisées autour d'une structure principale centrale dans laquelle est aménagé un logement destiné à recevoir la carte électronique de navigation et la batterie servant à alimenter en courant électrique les moteurs d'entraînement des groupes propulsifs et les cartes électroniques de commande associées, ainsi que la carte électronique de navigation.

Les groupes propulsifs situés aux centres des armatures circulaires sont reliés mécaniquement à la structure principale de la carène par des tubes par exemple en carbone. Les conducteurs nécessaires à la liaison électrique entre les moteurs d'entraînement, d'une part, et la batterie et la carte électronique de navigation, d'autre part, sont placés à l'intérieur des tubes de carbone.

Enfin, il convient de préciser que la carte électronique de navigation du drone comporte un capteur de navigation destiné à fournir des informations concernant la trajectoire, la vitesse, l'attitude du drone, etc. Le capteur de navigation peut être constitué par une centrale inertielle, un accéléromètre, un gyromètre, etc.

Un exemple de montage d'une carte électronique de navigation dans un drone à voilure tournante est décrit dans le document US 6 142 419.

La carte électronique de navigation étant reliée mécaniquement à la structure principale du drone, et la structure principale elle-même étant reliée mécaniquement aux groupes propulsifs via les tubes de carbone, on comprend que le capteur de navigation, porté par la carte électronique de navigation, n'est pas à l'abri des vibrations mécaniques produites par les groupes propulsifs lors du fonctionnement du drone. Or, les capteurs de navigation sont par nature même très sensibles aux vibrations. Il en résulte que des erreurs de lecture des capteurs induites par les vibrations peuvent entraîner des dysfonctionnements sévères du drone.

Le US 2004/0150144 A1 décrit un ensemble comprenant une carte électronique de navigation et un support destiné à être fixé dans un logement. Le support comporte une interface mécanique formée d'isolateurs constitués d'un matériau élastomère absorbant les vibrations mécaniques.

Cet ensemble est toutefois inadapté à un drone miniature tel qu'un jouet télécommandé, soumis à des vibrations mécaniques difficiles à filtrer compte tenu de la proximité entre les groupes propulsifs et le capteur de navigation à protéger.

Pour résoudre cette difficulté, il est possible d'utiliser un filtre numérique passe-bas appliqué au signal délivré en aval par le capteur de navigation, de manière à en éliminer les composantes dues aux vibrations mécaniques. Cependant, un tel traitement a l'inconvénient d'être complexe, de retarder la prise en compte du mouvement du drone et de conduire à une perte d'informations pertinentes du fait du filtrage passe-bas.

Aussi, un but de l'invention est de proposer un support de carte électronique de navigation qui permettrait de réduire, voire éliminer, les effets des vibrations parasites générées par les groupes propulsifs sur le fonctionnement du capteur de navigation, et ceci sans les inconvénients liés à la présence d'un filtre passe-bas.

Ce but est atteint, conformément à l'invention, grâce à un support de navigation pour un drone à voilure tournante du type général divulgué par le US 2004/0150144 A1 précité, c'est-à-dire comprenant une carte électronique de navigation et un support pour cette carte électronique, destiné à être fixé dans un logement. Le support comporte une interface mécanique avec le logement, constituée par un matériau absorbant les vibrations mécaniques.

L'interface mécanique absorbante interposée entre la carte électronique de navigation et le logement, ménagé notamment dans la structure principale du drone, permet d'isoler le capteur de navigation des vibrations mécaniques provenant des groupes propulsifs et reçues sur la structure principale du drone.

De façon caractéristique de l'invention, l'ensemble ci-dessus comprend : une pièce de fixation du support dans le logement, cette pièce de fixation portant l'interface mécanique, l'interface mécanique étant de forme annulaire et étant destinée à être rapportée sur un épaulement annulaire correspondant ménagé dans le logement ; au moins un pied de liaison, portant la carte électronique de navigation et monté libre à une extrémité à la pièce de fixation ; et une batterie d'alimentation du drone, logée dans le support et fixée à la pièce de fixation du support dans le logement.

Ainsi, la carte électronique de navigation est suspendue à la pièce de fixation par au moins un pied de liaison, sans aucun contact mécanique direct avec une pièce vibrante du drone. Les seules vibrations qui pourraient parvenir jusqu'à la carte électronique de navigation via la pièce de fixation sont éliminées par l'interface mécanique absorbante.

De plus, comme la batterie alimentant le drone en courant électrique est l'élément le plus lourd du système, il y a avantage à utiliser son inertie en la plaçant dans la carène en un endroit où elle puisse contribuer à limiter encore les vibrations transmises à la carte électronique de navigation. De cette manière, la batterie devient partie intégrante du système anti-vibrations en limitant le poids mort non suspendu.

On observera par ailleurs que l'élimination des vibrations parasites est effectuée en amont du capteur de navigation, de sorte que le signal fourni par ce dernier n'a nul besoin de traitement spécifique en aval, tel qu'un filtrage passe-bas avec tous les inconvénients qu'il présente.

Il faut également souligner que le support selon l'invention joue vis-à-vis de la carte électronique de navigation le rôle d'amortisseur de chocs à l'atterrissage du drone et évite l'usure, due aux vibrations, des connecteurs électriques disposés sur la carte électronique de navigation. Avantageusement, la carte électronique de navigation comporte un capteur de navigation disposé sur ladite carte de manière à être positionné au barycentre du drone.

Dans cette position idéale pour le capteur de navigation, il est possible d'envisager que ledit capteur de navigation est un accéléromètre, sans avoir besoin d'ajouter un composant d'acquisition de l'inclinaison du drone, comme un gyromètre par exemple. En effet, un accéléromètre placé au barycentre du drone peut fournir les mêmes indications qu'un gyromètre, en particulier la direction de la gravité (fonction d'inclinomètre). Le nombre de composants dédiés à la navigation est donc réduit ainsi que leur coût, un accéléromètre étant sensiblement moins cher qu'un gyromètre. De plus, le domaine de la mesure d'angle n'est pas limité, à la différence d'un gyroscope mécanique qui fonctionne correctement sur une plage de ± 30°, mais qui n'est plus contrôlable au-delà.

Dans un mode de réalisation avantageux, la batterie est fixée à ladite pièce de fixation du support par une bande agrippante. Ce type de fixation par bande agrippante est de manipulation très aisée par rapport à une fixation par vis par exemple. De plus, elle contribue à la réduction des vibrations et évite les jeux mécaniques susceptibles de perturber les mesures d'accélération.

En pratique, le matériau absorbant peut être une mousse de matériau thermodurcissable, notamment une mousse de polyuréthanne.

De préférence, l'interface mécanique en matériau absorbant est fixée au logement par collage. Cette disposition permet d'obtenir une meilleure absorption des efforts de cisaillement appliqués au support. L'invention prévoit en outre que l'interface mécanique en matériau absorbant est fixée au support de la même façon, par collage.

Enfin, l'invention couvre également un drone à voilure tournante comprenant un support de carte électronique de navigation tel que ci-dessus.

On va maintenant décrire un exemple de mise en oeuvre du dispositif de l'invention, en référence aux dessins annexés où les mêmes références numériques désignent d'une figure à l'autre des éléments identiques ou fonctionnellement semblables.
La Figure 1 est une vue en perspective d'un drone à voilure tournante conforme à l'invention.
La Figure 2a est une vue en perspective de la structure principale du drone de la Figure 1, montrant un support de carte électronique de navigation conforme à l'invention.
La Figure 2b est une vue en transparence de la structure principale de drone de la Figure 2a.
La Figure 3 est une vue en perspective du support de carte électronique de navigation des Figures 2a et 2b.
La Figure 4 est une vue en coupe de la structure principale de drone des
Figures 2a et 2b.

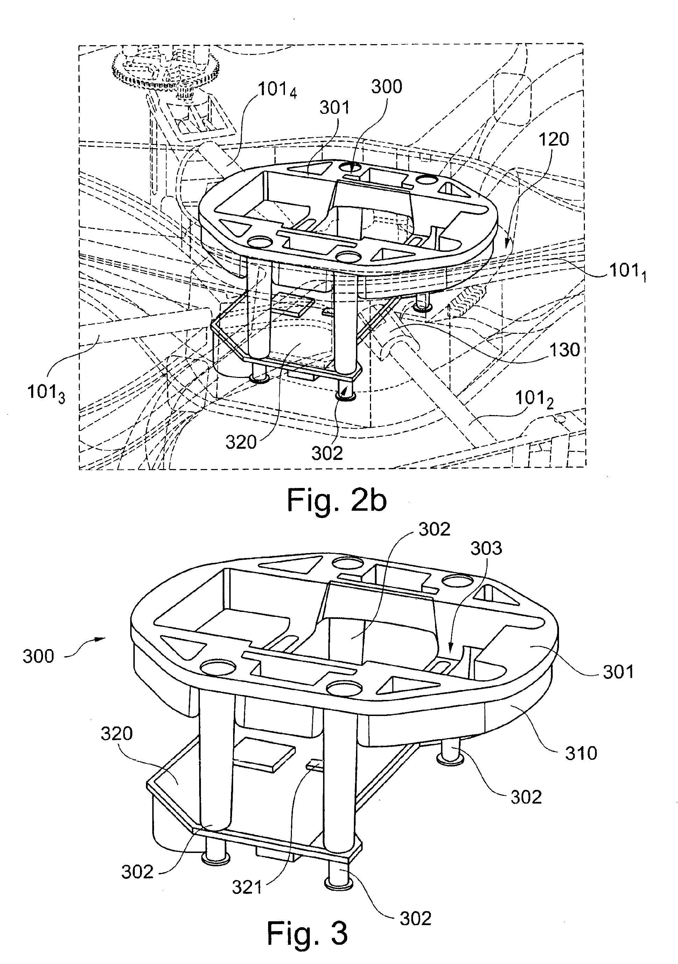

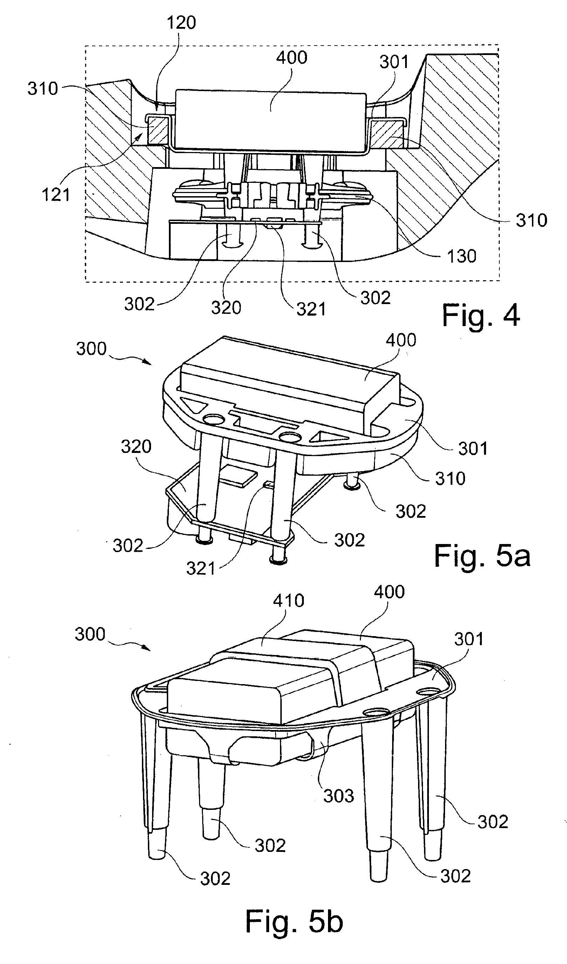

La Figure 5a est une vue en perspective du support de carte électronique de navigation de la Figure 3, équipé d'une batterie d'alimentation électrique.
La Figure 5b est une vue en perspective du support de carte électronique de navigation de la Figure 5a montrant un système de fixation de la batterie par bande agrippante.

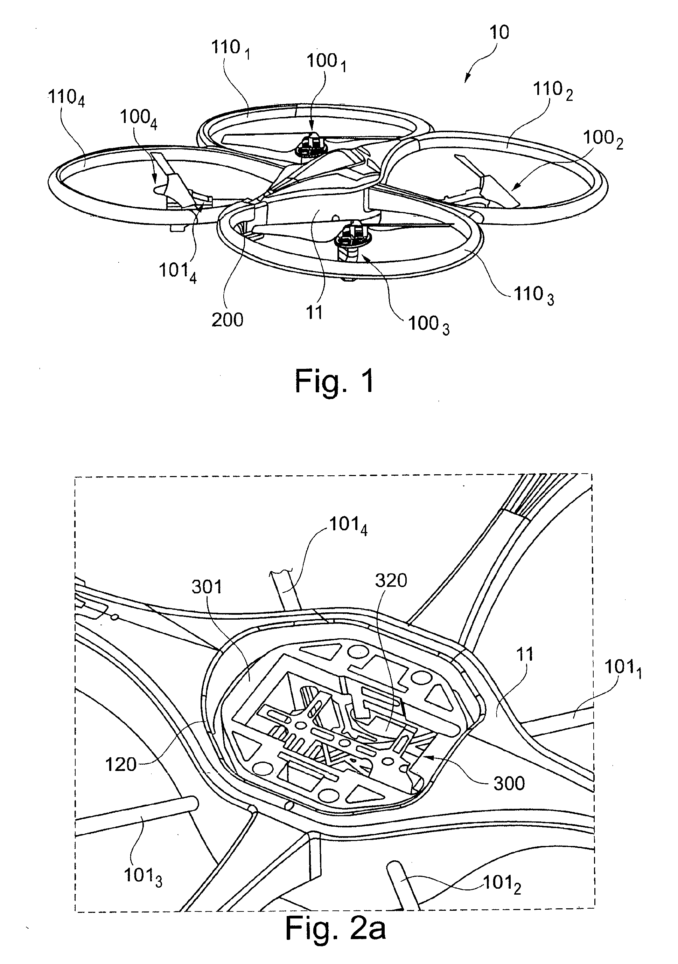

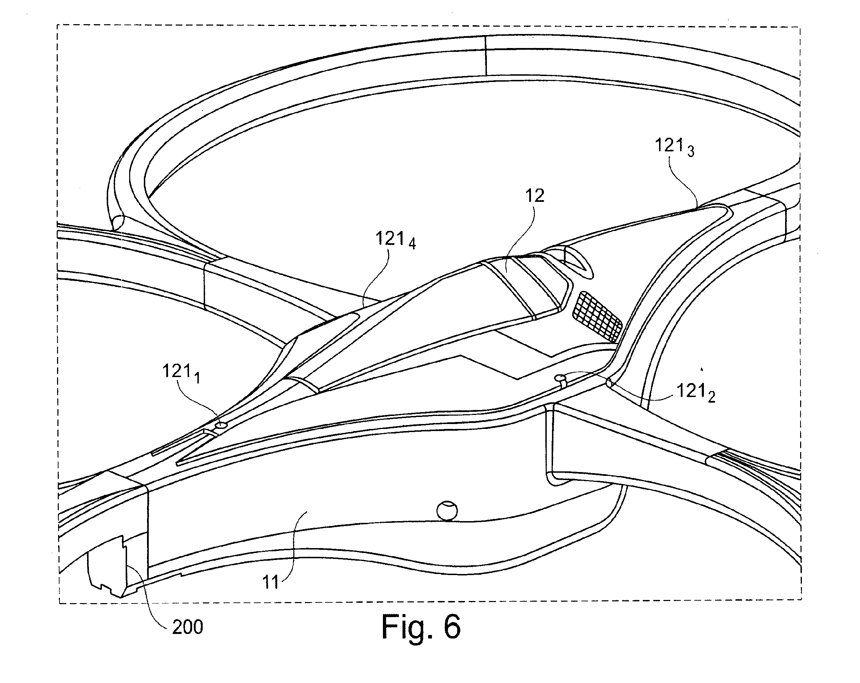

La Figure 6 est une vue partielle en perspective du drone de la Figure 1 montrant un capot de fermeture à fixation magnétique de la structure principale.

La description qui va suivre en regard des dessins annexés, donnés à titre d'exemples non limitatifs, fera bien comprendre en quoi consiste l'invention et comment elle peut être réalisée.

Sur la Figure 1 est représenté un quadricoptère 10 constituant un drone dont la voilure tournante est composée de quatre groupes propulsifs coplanaires 100₁, 100₂, 100₃, 100₄. Chaque groupe propulsif comprend une hélice couplée à un système de réduction de la vitesse de rotation d'un moteur électrique d'entraînement.

La carène du drone 10 est composée de quatre armatures circulaires 110₁, 110₂, 110₃, 110₄ en polypropylène expansé aux centres desquelles sont placés les groupes propulsifs 100₁, 100₂, 100₃, 100₄. Les armatures circulaires sont solidarisées entre elles par une structure principale 11 comprenant notamment les éléments de navigation du drone qui seront décrits en détail plus loin.

Comme le montre la Figure 1, les armatures circulaires sont disposées en carré, ceci de manière à pouvoir installer une caméra 200 de prise de vue au plus proche du centre du drone 10, et donc de réduire le moment d'inertie de la caméra et raccourcir les connexions électriques entre la caméra et la structure principale 11.

Les groupes propulsifs 100₁, 100₂, 100₃, 100₄ sont reliés mécaniquement à la structure principale 11 de la carène du drone 10 par des tubes 101₁, 101₂, 101₃, 101₄ de carbone, mieux visibles sur la Figure 2a.

Les tubes 101₁, 101₂, 101₃, 101₄ de carbone contiennent également des conducteurs électriques qui s'étendent entre la structure centrale 11 de la carène et les moteurs d'entraînement des groupes propulsifs. Ces conducteurs permettent d'alimenter en courant le moteur proprement dit de chaque groupe propulsif ainsi que le circuit de commande associé, conformément à un signal de commande fourni en fonction des paramètres de vol par une carte électronique 320 de navigation logée dans la structure principale 11.

Sur les Figures 2a, 2b, 3 et 4, on peut voir que la carte électronique 320 de navigation portant un capteur 321 de navigation du type accéléromètre par exemple, est fixée à un support 300, lequel est disposé dans un logement 120 ménagé dans la structure principale 11.

Plus précisément, le support 300 de la carte électronique 320 est constitué en deux parties, à savoir une pièce 301 de fixation du support dans le logement 120, et des pieds, référencés ensemble 302, montés libres sur la pièce 301 de fixation à une extrémité, la carte électronique 320 de navigation avec le capteur 321 étant suspendue à une autre extrémité des pieds 302.

La pièce 301 du support 300 est fixée dans le logement 120 par l'intermédiaire d'une interface mécanique 310 constituée par un matériau absorbant les vibrations mécaniques, en particulier une mousse en matériau thermodurcissable, notamment du polyuréthanne.

Dans l'exemple de réalisation montré sur les figures précitées, l'interface absorbante 310 portée par la pièce 301 de fixation a une forme annulaire de manière à pouvoir être rapportée sur un épaulement annulaire 121 correspondant ménagé dans le logement 120, sans être en contact mécanique avec aucun autre élément du logement et de la structure principale 11.

D'autre part, on peut observer sur la Figure 2b en particulier que les tubes 101₁, 101₂, 101₃, 101₄ de carbone sont solidarisés entre eux par une pièce 130 de liaison en forme de croix, sans aucun contact mécanique avec le support 300 de la carte électronique 320 de navigation.

En conclusion, les vibrations mécaniques engendrées par les groupes propulsifs 100₁, 100₂, 100₃, 100₄ au cours du fonctionnement du drone 10 sont transmises à la structure principale 11 par l'intermédiaire des tubes 101₁, 101₂, 101₃, 101₄ de carbone, mais ne peuvent être transmises au support 300 du fait que la seule interface mécanique 310 entre la structure principale 11 et le support 300 est prévue par l'invention pour absorber les vibrations. Il en résulte que les mesures fournies par le capteur 321 de navigation ne sont pas perturbées par les vibrations mécaniques des groupes propulsifs du drone et qu'aucun dysfonctionnement ne peut se produire à ce titre.

De préférence, la pièce 301 de fixation est collée à la mousse de polyuréthane formant l'interface mécanique 310. De même, cette dernière est collée sur l'épaulement 121 du logement 120. On obtient ainsi une meilleure résistance aux efforts de cisaillement et le maintien en position de la carte 320 électronique de navigation en cas de retournement du drone 10. Par ailleurs, le capteur 321 de navigation peut être positionné sur la carte électronique 320 de navigation de manière à être placé au centre de gravité du drone 10. Cette disposition permet d'éviter l'utilisation d'un gyromètre au profit d'un accéléromètre, moins cher, puisque dans cette position privilégiée un accéléromètre peut également fonctionner en inclinomètre pour fournir notamment la direction de la gravité.

Sur les Figures 4, 5a et 5b, on a montré que le support 300 de la carte électronique 320 de navigation sert également à loger la batterie 400 du drone 10. Pour cela un berceau 303 est aménagé dans la pièce 301 de fixation pour accueillir la batterie 400. Dans cette configuration, l'inertie de la batterie s'ajoute à celle du support 300 et, en limitant le poids mort non suspendu, elle contribue également à l'absorption des vibrations mécaniques.

Comme l'illustre la Figure 5b, la batterie 400 peut être maintenue en position dans le berceau 303 au moyen d'une bande agrippante 410. Ce mode de fixation est très simple d'utilisation et exempt de jeux mécaniques qui pourraient être à l'origine d'erreurs dans les indications fournies par l'accéléromètre 321.

Enfin, la Figure 6 montre un drone 10 dont le logement contenant le support de carte électronique de navigation et la batterie est fermé par un capot 12 de protection fixé à la structure principale 11 par des moyens de d'ouverture et de fermeture magnétique, tels que des aimants permanents 121₁, 121₂, 121₃, 121₄. Ce système de fixation par aimants est d'utilisation très rapide et très simple car il n'exige aucun outillage particulier, notamment aucun tournevis.

## Revendications

1. Ensemble comprenant :
- une carte électronique de navigation (320) pour un drone (10) à voilure tournante ; et
- un support (300) pour cette carte électronique, destiné à être fixé dans un logement (120) ménagé dans le drone, le support comportant une interface mécanique avec le logement, constituée par un matériau absorbant les vibrations mécaniques,
ensemble **caractérisé en ce qu'**il comprend :
- une pièce de fixation (301) du support dans le logement, cette pièce de fixation portant l'interface mécanique (310),
l'interface mécanique étant de forme annulaire et étant destinée à être rapportée sur un épaulement annulaire (121) correspondant ménagé dans le logement ;
- au moins un pied de liaison (302), portant la carte électronique de navigation et monté libre à une extrémité à la pièce de fixation ; et
- une batterie (400) d'alimentation du drone, logée dans le support (300) et fixée à la pièce de fixation (301) du support dans le logement.

2. Ensemble selon la revendication 1, dans lequel la carte électronique de navigation (320) comporte un capteur de navigation (321) disposé sur cette carte de manière à être positionné au barycentre du drone (10).

3. Ensemble selon la revendication 2, dans lequel le capteur de navigation (321) est un accéléromètre.

4. Ensemble selon la revendication 1, dans lequel la batterie est fixée par une bande agrippante (410) à la pièce de fixation.

5. Ensemble selon la revendication 1, dans lequel le matériau absorbant est une mousse de matériau thermodurcissable.

6. Ensemble selon la revendication 1, dans lequel l'interface mécanique en matériau absorbant est fixée au logement par collage.

7. Ensemble selon la revendication 1, dans lequel l'interface mécanique en matériau absorbant est fixée au support par collage.

8. Drone à voilure tournante, comprenant un ensemble selon l'une des revendications 1 à 7.

9. Drone selon la revendication 8, comprenant un capot (12) à fixation magnétique de fermeture du logement (120).

## Patentansprüche

1. Anordnung, die Folgendes umfasst:
- eine elektronische Navigationskarte (320) für eine Drehflügel-Drohne (10); und
- einen Träger (300) für diese elektronische Karte, der dazu bestimmt ist, in einem in der Drohne ausgebildeten Aufnahmeraum (120) befestigt zu werden, wobei der Träger eine mechanische Schnittstelle mit dem Aufnahmeraum aufweist, die durch ein Material, das mechanische Vibrationen absorbiert, gebildet ist, wobei die Anordnung **dadurch gekennzeichnet ist, dass** sie Folgendes umfasst:
- ein Teil (301) für die Befestigung des Trägers in dem Aufnahmeraum, wobei dieses Befestigungsteil die mechanische Schnittstelle (310) trägt,
wobei die mechanische Schnittstelle ringförmig ist und dazu bestimmt ist, an eine entsprechende ringförmige Schulter (121), die in dem Aufnahmeraum ausgebildet ist, angefügt zu werden;
- wenigstens einen Verbindungsfuß (302), der die elektronische Navigationskarte trägt und an einem Ende des Befestigungsteils frei montiert ist; und
- eine Batterie (400) für die Versorgung der Drohne, die sich in dem Träger (300) befindet und an dem Befestigungsteil (301) des Trägers in dem Aufnahmeraum befestigt ist.

2. Anordnung nach Anspruch 1, wobei die elektronische Navigationskarte (320) einen Navigationssensor (321) umfasst, der auf dieser Karte in der Weise angeordnet ist, dass er im Schwerpunkt der Drohne (10) positioniert ist.

3. Anordnung nach Anspruch 2, wobei der Navigationssensor (321) ein Beschleunigungsmesser ist.

4. Anordnung nach Anspruch 1, wobei die Batterie durch ein Klammerband (410) an dem Befestigungsteil befestigt ist.

5. Anordnung nach Anspruch 1, wobei das absorbierende Material ein Schaumstoff aus wärmeaushärtbarem Material ist.

6. Anordnung nach Anspruch 1, wobei die mechanische Schnittstelle aus absorbierendem Material in dem Aufnahmeraum durch Kleben befestigt ist.

7. Anordnung nach Anspruch 1, wobei die mechanische Schnittstelle aus absorbierendem Material an dem Träger durch Kleben befestigt ist.

8. Drehflügel-Drohne, die eine Anordnung nach einem der Ansprüche 1 bis 7 umfasst.

9. Drohne nach Anspruch 8, die eine Haube (12) mit magnetischer Befestigung zum Verschließen des Aufnahmeraums (120) umfasst.

## Claims

1. A unit comprising:
- an electronic navigation board (320) for a rotary-wing drone (10); and
- a support (300) for this electronic board, intended to be fixed in a housing (120) provided in the drone,
the support having a mechanical interface with the housing, consisted of a material absorbing the mechanical vibrations,
the unit being **characterized in that** it comprises:
- a part (301) for the fixation of the support in the housing, this fixation part carrying the mechanical interface (310),
the mechanical interface being annular in shape and being intended to be added on a corresponding annular shoulder (121) provided in the housing;
- at least one linking leg (302), carrying the electronic navigation board and mounted freely at one end of the fixation part; and
- a battery (400) for powering the drone, housed in the support (300) and fixed to the part (301) for the fixation of the support in the housing.

2. The unit according to claim 1, wherein the electronic navigation board (320) includes a navigation sensor (321) arranged on this board in such a manner to be positioned at the barycentre of the drone (10).

3. The unit according to claim 2, wherein the navigation sensor (321) is an accelerometer.

4. The unit according to claim 1, wherein the battery is fixed by a fastening band (410) to the fixation part.

5. The unit according to claim 1, wherein the absorbing material is a foam of thermosetting material.

6. The unit according to claim 1, wherein the mechanical interface made of an absorbing material is adhesively fixed to the housing.

7. The unit according to claim 1, wherein the mechanical interface made of an absorbing material is adhesively fixed to the support.

8. A rotary-wing drone, comprising a unit according to one of claims 1 to 7.

9. The drone according to claim 8, comprising a magnetic-fixation lid (12) for the closing of the housing (120).
